# EUROPÄISCHE PATENTSCHRIFT

(11) **EP 3 815 476 B1**
(45) Veröffentlichungstag und Bekanntmachung des Hinweises auf die Patenterteilung: **07.08.2024**
(21) Anmeldenummer: 19729240.2
(22) Anmeldetag: 04.06.2019
(51) Int. Cl.: H05K 5/00, H05K 5/06

(54) **ELEKTRONIKMODUL MIT STECKERANSCHLUSS**
ELECTRONICS MODULE WITH PLUG CONNECTION
MODULE ÉLECTRONIQUE À RACCORD DE CONNECTEUR

(30) Priorität: 28.06.2018 DE 102018210621
(43) Veröffentlichungstag der Anmeldung: 05.05.2021
(73) Patentinhaber: Robert Bosch GmbH, 70442 Stuttgart (DE)
(72) Erfinder: GUECKEL, Richard, 76829 Landau (DE); KAMMER, Gerald, 71640 Ludwigsburg (DE)
(86) Internationale Anmeldenummer: PCT/EP2019/064518
(87) Internationale Veröffentlichungsnummer: WO 2020/001937

(56) Entgegenhaltungen:
- DE-A1- 102008 043 774
- DE-A1- 102008 051 545

## Beschreibung

Die Erfindung betrifft ein Elektronikmodul mit einem Steckeranschluss und ein Verfahren zum Ausbilden des Elektronikmodules gemäß dem Oberbegriff der unabhängigen Ansprüche.

### Stand der Technik

Elektronikeinheiten weisen insbesondere zum Schutz vor Medien und/oder mechanischen Krafteinwirkungen eine Umhausung auf. Eine sehr kompakte Umhausung wird durch das Einmolden der Elektronikeinheit in einer Moldmasse erhalten. Solche Moldmodule erfordern zum elektrischen Anschluss der Elektronikeinheit einen externen Steckeranschluss.

Aus der Offenlegungsschrift US 2005/0057902 A1 ist ein elektronisches Steuergerät als Moldmodul bekannt, bei welchem neben einem bestückten Schaltungsträger zusätzlich ein mit dem Schaltungsträger elektrisch verbundenes Steckeranschlusselement ummoldet ist. Die Moldmasse reicht hierbei bis zu einem äu-ßeren Bereich eines isolierenden Steckerkörpers des Steckerelementes. Da die Moldmasse und der Steckerkörper in der Regel aus unterschiedlichen Materialien gebildet sind, ist nicht immer ein ausreichend guter Stoffschluss gewährleistet. Durch eine schwache Anbindung der Materialien zueinander besteht die Gefahr, dass zumindest mit der Zeit Medien oder Feuchtigkeit durch Mikrospalte und - risse bis zum Schaltungsträger gelangen und dort elektrische Störungen bis hin zu einem Ausfall verursachen. Die Problematik kann sich weiter verschlechtern aufgrund der mechanischen Krafteinwirkung von Steckvorgängen eines Gegensteckers. Im schlimmsten Fall wird durch die stetige Krafteinwirkung zumindest bereichsweise eine Delamination der beiden Materialien begünstigt und ein Eindringen von Medien und/oder Feuchtigkeit wahrscheinlicher. Gleiches gilt für eine Delamination, die bei Temperaturwechsel durch unterschiedliche Ausdehnungskoeffizienten der Materialien entstehen kann. Derartige Ausführungen zeigen demnach oft ein Dichtigkeitsproblem auf.

Darüber hinaus sind auch Moldmodule bekannt, wie eines beispielhaft in der Offenlegungsschrift DE102012204630 A1 gezeigt ist. Zur externen elektrischen Kontaktierung weist das Moldmodul eine sogenannte Direktkontaktierung auf, bei welcher eine in einer thermoplastischen Moldmasse eingehauste bestückte Leiterplatte mit einem Randbereich aus der Umhausung herausragt. Der Randbereich weist elektrische Kontaktbereiche auf zur direkten elektrischen Kontaktierung mit einem Gegenkontaktstecker. Grundsätzlich ist eine Direktkontaktierung durch die technologischen Randbedingungen hinsichtlich der elektrischen Kontaktfunktionen sehr anspruchsvoll und in der Auswahl durch die technologischen Grenzen der Leiterplatte eingeschränkt. Auch hier zeigen sich bedingt durch schwierige konstruktive Auslegungsbedingungen oft Dichtigkeitsprobleme. Zusätzlich ist auf Seiten des erforderlichen Gegenkontaktsteckers, insbesondere als kabelbaumseitiger Gegenstecker, ein wesentlich größerer konstruktiver Aufwand erforderlich als bei standardmäßig eingesetzten Gegensteckern in Form einer Messerleiste. Dadurch ergeben sich oft höhere Kosten und/oder eine geringere Performance.

Aus der Offenlegungsschrift DE102008051545 A1 ist ein Elektronikmodul bekannt, bei welchem in einem Teilgehäuse auch ein Steckerkragen ausgebildet ist. Der Steckerkragen bildet eine Aufnahmeöffnung für einen Gegenstecker dar. Innerhalb des Steckerkragens ist ein Pinträger eingeschoben zur elektrischen Kontaktierung des Elektronikmodules mit dem Gegenstecker. Die im Pinträger enthaltenen Steckerpins sind einseitig mit einem Schaltungsträger verbunden. Der Schaltungsträger ist bei eingeschobenen Pinträger innerhalb des Teilgehäuses angeordnet. Das Teilgehäuse weist in diesem Zustand noch eine einseitige Öffnung auf. Ein geschlossenes Gehäuse ergibt sich durch Verschließen mittels eines weiteren Teilgehäuses in Form eines Gehäusedeckels.

Die Offenlegungsschrift DE102008043774 A1 zeigt eine gemeldete Ausführung eines Elektronikmoduls. Dabei ist ein wesentlicher Teil eines Schaltungsträgers von einer Moldmasse umschlossen unter Ausbildung eines Moldgehäuses. Als elektrische Anschlussmöglichkeit des Elektronikmoduls ragen Anschlusspins aus dem Moldgehäuse heraus. Lokal weist das Gehäuse Öffnungen auf, innerhalb welchen der Schaltungsträger von der Moldmasse freiliegt.

### Offenbarung der Erfindung

### Vorteile

Der Erfindung liegt die Aufgabe zu Grunde, eine dichte und kostengünstige Steckverbindung bei Elektronikmodulen mit einem Steckeranschluss, umfassend Steckerpins wie bei einer Messerleiste, zu ermöglichen.

Diese Aufgabe wird durch ein Elektronikmodul mit einem Steckeranschluss und ferner einem Verfahren zur Ausbildung des Elektronikmodules mit den kennzeichnenden Merkmalen des unabhängigen Anspruches gelöst.

Ausgegangen wird von einem Elektronikmodul, umfassend zumindest einen bestückten Schaltungsträger mit einem Steckeranschluss zur elektrischen Kontaktierung mit einem Gegenstecker, wobei der Steckeranschluss einen elektrisch isolierenden Steckerkörper mit zumindest einem Steckerkragen umfasst, durch welchen eine Öffnung zur Aufnahme des Gegensteckers in Richtung eines Steckergrundes ausgebildet ist. Dabei weist der Steckerkörper einen Dichtbereich gegenüber dem Gegenstecker auf und ist innerhalb der Öffnung von einer Anzahl von Steckerpins durchdrungen. Die Steckerpins, die dann auf der dem Steckerkragen zugewandten Seite (Steckerseite des Steckeranschlusses) angeordnet sind, sind mit dem Gegenstecker elektrisch kontaktierbar, wogegen die auf der dem Steckerkragen abgewandten Seite (Anschlussseite des Steckeranschlusses) mit dem Schaltungsträger elektrisch kontaktiert sind, beispielsweise über einen Lot- oder Einpresskontakt. Der bestückte Schaltungsträger ist des Weiteren unter Ausbildung einer Schutzumhausung zumindest bereichsweise von zumindest einer verfestigten Umhüllungsmasse umschlossen. Dabei sind der Steckerkragen und die Schutzumhausung einstückig aus der verfestigten Umhüllungsmasse ausgebildet. Ferner weist der Steckeranschluss innerhalb der Öffnung einen Pinträger aufweist, welcher zumindest den von den Steckerpins durchdrungenen Bereich des Steckerkörpers ausbildet und welcher dabei von der Umhüllungsmasse zumindest teilweise umschlossen ist. Hierbei ist der Dichtbereich außerhalb des Pinträgers am Steckerkragen ausgebildet. Der Dichtbereich umfasst beispielsweise eine Dichtfläche und/oder einen an die Dichtfläche anliegendes Dichtelement, beispielsweise einen O-Ring. Alternativ kann der Dichtbereich auch ein Dichtelement sein, welches teilweise in der verfestigten Umhüllungsmasse eingebettet oder eingeklebt ist oder nach einem Einspritzen einer Dichtungsmasse als das Dichtungselement ausgebildet ist. Insgesamt ergibt sich der Vorteil, dass ein außerhalb des Dichtbereiches einem Medium oder Feuchtigkeit ausgesetzter Bereich des Elektronikmodules nun eine vollständig geschlossene Außenfläche aus der verfestigten Umhüllungsmasse aufweist. In Bezug auf die Sicherstellung einer Dichtigkeit ist nun lediglich die Auswahl für ein geeignetes Material der Umhüllungsmasse in Hinblick auf vorgegebene Einsatzbedingungen des Elektronikmodules zu treffen. Im abgedichteten Bereich wirken sich mögliche Haftungsschwierigkeiten unterschiedlicher Materialien oder deren mögliche Delamination aufgrund von Krafteinwirkungen und/oder unterschiedlichen Ausdehnungskoeffizienten nicht mehr als Dichtungsproblem für das Elektronikmodul aus. Durch Einsatz eines Pinträgers vereinfacht sich die Ausformung einer Steckergeometrie des Steckeranschlusses, da die Steckpins auf der Steckerseite nicht mehr einzeln gegenüber einer fließfähigen Umhüllungsmasse abzudichten sind. Insgesamt liegt vorteilhaft ein integral im Elektronikmodul ausgebildeter Steckeranschluss vor, der in einfacher Weise in Bezug auf Steckergeometrien und Steckerabdichtungskonzept bekannten Messerleisten entspricht oder sich an diesen orientieren kann. Zeitgleich können damit auch bekannte Gegenstecker ohne Änderungen zum Einsatz kommen, so dass im Zusammenspiel mit derartigen Gegensteckern von eine bewährten und gesicherten dichten Steckverbindung auszugehen ist.

In einer vorteilhaften Ausführungsform des Elektronikmodules ist die Umhüllungsmasse aus einem Duroplasten. Duroplasten zeigen eine gute Medienbeständigkeit und lassen sich durch etablierte Fertigungsverfahren, beispielsweise durch ein Direct-Injection-Molding-Verfahren, durch ein Transfermolding-Verfahren, durch ein Compressionsmold-Verfahren oder durch ein Spritzgussverfahren, zum Umhausen von Elektronikeinheiten einsetzen. Darüber hinaus weisen die Duroplaste eine hohe mechanische Belastbarkeit, so dass Steckerkräfte durch wiederholte Steckvorgänge oder -belastungen unbeschadet aufgenommen werden können. Bevorzugt sind hierbei BMC Formassen (BMC: bulk moulding compound) eingesetzt, welche einen teigförmigen Formstoff geben. Dabei sind Polyesterharze (UP) und Vinylesterharze (VP) als besonders geeignete Materialien zu nennen. Daneben eignen sich weiter vorteilhaft auch Epoxidformmassen, die in einem Ausgangszustand rieselfähig sind und beispielsweise beim Spritzgießen eingesetzt sind.

Weitere Vorteile ergeben sich bei einer Ausführungsform des Elektronikmodules, bei welcher der Pinträger aus einem Thermoplasten ausgebildet ist. Hierbei kann kostengünstig auf bewährte Herstellverfahren zurückgegriffen werden, durch welche ein Steckerelement erhalten werden kann, welches gebildet ist aus dem von Steckerpins durchdrungenen Pinträger. Die Steckerpins als elektrische Kontakte des Steckerelements sind beispielsweise aus einer Zinnbronze (CuSn, Messing, Neusilber) oder anderen hierfür bekannten Hochleistungslegierungen. Diese werden im Spritzgießverfahren mit einem vorzugsweise amorphen Kunststoff entweder in einen freifallenden thermoplastischen Spritzgießkörper bestückt (engl: Stitchen) oder über eine Bestückleiste in ein Spritzgusswerkzeug eingesetzt und von dem Thermoplast umspritzt. Als besonders geeignete Thermoplasten zeigen sich hierbei Polyethersulfon (PESU), Polysulfon (PSU) oder Polycarbonat (PC). Ferner eignen sich auch andere amorphe Kunststoffe, die auch bei > 100°C eine ausreichende Wärmestabilität für eine weitere oben genannte Duroplast Umspritzung aufweisen. Darüber hinaus eignen sich auch vorteilhaft ataktisches Polystyrol (PS) und Polyvinylchlorid (PVC) als Thermoplast-Material. Amorphe Thermoplasten weisen dabei den Vorteil auf, dass ein Schmelzbereich aufgrund der unmittelbaren Nähe der Glastemperatur zur Schmelztemperatur abrupt eintritt und dieses Material nicht unter Blasenbildung aufschäumt, wie beispielsweise bei teilkristallinen Werkstoffen (Polyamid PA, Polybutilenterephtalat PBT), sondern honigartigen zu fließen beginnt. Unter Ausnutzung dieser Materialeigenschaft lassen sich besonders spritzdichte Steckerelement im Bereich des Pinträgers und der Steckerpins bereitstellen. So können bei nach zuvor oben beschriebenen bekannten Fertigungsverfahren ausgebildete Steckerelementen, die ggf. noch kleinste Spalte zwischen dem Pinträger und den jeweiligen Steckerpins aufweisen, diese in einfacher Weise geschlossen werden. Dies kann beispielsweise dadurch erfolgen, dass einzelne oder gleichzeitig mehrere Steckerpins stromdurchflutet werden, wobei eine Durchflutungszeit und eine Stromstärke ausgewählt ist, bei welcher die stromdurchflutenden Steckerpins auf eine Temperatur oberhalb der Schmelztemperatur des Thermoplasts erwärmt werden. Im Bereich eines jeweiligen Steckerpins schmilzt das dort vorliegende Thermoplastmaterial auf, wodurch dieses in Spaltabstände nachfließen kann. Nach einem Erstarren der geschmolzenen Bereiche sind dann somit die ursprünglichen Spalte geschlossen. Das somit spritzdicht ausgeführte Steckerelement kann als Einlegeteil für die Ausbildung des Elektronikmodules eingesetzt werden, ohne dass Gefahr besteht, dass noch fließfähige Umhüllungsmasse von der Anschlussseite zur Steckseite entlang der Steckerpins gelangen kann. Es bestehen auch andere Möglichkeiten das Steckerelement spritzdicht auszuführen, beispielsweise durch Vergelen und damit Verschließen von möglichen Spalten auf der Stecker- und/oder Anschlussseite. Alternativ können die Steckerpins eine auf der Anschlussseite angeordnete Mattendichtung oder Klebestreifen mit durchdringen und dabei ein engeres Anliegen der Mattendichtung oder des Klebestreifens im durchdrungenen Bereich spritzdicht erwirken. Ebenso ist ein Einstichen der Steckerpins im noch spritzwarmen Pinträger denkbar oder ein Vergießen der Steckerpins auf der Anschlussseite mittels einer erstarrenden Vergussmasse. Insgesamt zeigt sich in einem unmittelbaren Berührbereich zwischen dem Pinträger aus dem Thermoplasten und der Umhüllungsmasse aus einem Duroplasten ein gutes Haftungsvermögen. Dadurch ist die Gefahr einer Delamination gering und eine Kraftaufnahme unbedenklich. In anderen möglichen Ausführungen ist der Pinträger aus einem Duroplasten.

Bei einer bevorzugten Ausführungsform des Elektronikmodules ist der Dichtbereich im Eingangsbereich der Öffnung und/oder innerhalb der Öffnung angeordnet. Auf diese Weise kann nahezu oder vollständig die von außen sichtbare Außenfläche des Elektronikmodules geschlossen aus der Umhüllungsmasse ausgeführt sein. Dadurch erhöht sich insgesamt die Sicherheit der Dichtigkeit. Zusätzlich ist in der Regel die Fertigung durch ein Ausformwerkzeug vereinfacht.

Grundsätzlich ist das Elektronikmodules derart ausgeführt, dass der Pinträger auf einer dem Gegenstecker zugewandten Steckerseite zumindest eine nach außen weisende Pinträgerfläche aufweist, die von der Umhüllungsmasse freiliegt, wobei eine zur Umhüllungsmasse angrenzende Berandung der Pinträgerfläche die Steckerpins umrahmt. Auf diese Weise ist die Gefahr unterbunden, dass die auf der Steckerseite angeordneten Steckerpins von der Umhüllungsmasse kontaminiert wird. Grundsätzlich ist es denkbar, mehrere freiliegende Pinträgerflächen mit dann jeweils einer umrahmten Steckerpingruppe. In Hinblick auf eine kostengünstige Fertigung ist genau eine freiliegende Pinfläche ausgebildet, welche alle Steckerpins umrahmt.

Ferner ergibt sich eine Verbesserung dadurch, dass in einer Ausführungsform des Elektronikmodules der Bereich der Berandung der Pinträgerfläche eine Werkzeugdichtfläche umfasst, insbesondere in Form einer Schmelzrippe, welche ausgebildet ist, die Pinträgerfläche während einer Ausbildung der Schutzumhausung und des Steckerkragens gegenüber noch nicht verfestigter Umhüllungsmasse mittels der Auflage zumindest eines Teiles eines Ausformwerkzeuges von der Umhüllungsmasse freizuhalten.

Allgemein ist vorteilhaft, wenn die Berandung der Pinträgerfläche bis höchstens angrenzend zum Dichtbereich reicht. Insofern ist ein Berührbereich zwischen dem Pinträger und der Umhüllungsmasse immer nur innerhalb eines ansonsten bei einer Steckverbindung mit einem Gegenstecker abgedichteten Bereiches des Steckeranschlusses angeordnet ist. Insofern besteht kein Dichtigkeitsproblem wie bei ansonsten bekannten Ausführungen aus dem Stand der Technik. Dabei ist es vorteilhaft, dass die Berandung insbesondere bis höchstens zu einer Einstecktiefe des Gegensteckers innerhalb der Öffnung reicht. Damit kein kann Innenfläche der Öffnung in Bezug auf einen Steckvorgang für den Gegenstecker optimiert werden, insbesondere ohne Stoßstellen unterschiedlicher Materialien. Bevorzugt ist die Berandung noch innerhalb des Steckergrundes ausgebildet, beispielsweise mit einer Beabstandung zur seitlichen angrenzenden Innenfläche der Öffnung. Dadurch ist der Steckeranschluss mechanisch sehr stabil ausgeführt, indem der abstehende Steckerkragen ganzheitlich aus der Umhüllungsmasse, insbesondere aus Duroplast, gebildet ist. Die Fläche des Steckergrundes ist bevorzugt senkrecht zur Steckrichtung des Gegensteckers bzw. senkrecht zu einer Ausrichtachse der Öffnung orientiert.

Es zeigt sich eine besonders vorteilhafte Ausführungsform des Elektronikmodules darin, dass zumindest ein Teil der Flächen des Steckerkragens in Steckrichtung des Gegensteckers Entformungsschrägen eines Abformwerkzeuges aufweisen, insbesondere innerhalb der Öffnung, wobei durch die entsprechend zugeordneten entformten Flächen eine innere und/oder äußere korrespondierende Steckergeometrie für den Gegenstecker ausgebildet ist. Die Entformung kann hier beispielsweise durch ein Schiebewerkzeug innerhalb eines Abformwerkzeuges erfolgen, wodurch auch sehr komplexe Steckergeometrien ausbildbar sind.

Große Vorteile hinsichtlich Erreichung einer Fertigungsgenauigkeit ergeben sich dadurch, dass der Pinträger Referenzelemente umfasst, welche ausgebildet sind in Anlagenkontakt mit zumindest einem Teil eines Abformwerkzeuges dieses relativ zu den Steckerpins zu positionieren, um bei der Ausbildung der korrespondierenden Steckergeometrie diese in Bezug zu den Steckerpins lagerichtig festzulegen. Bevorzugt sind zumindest ein, zwei oder weitere Steckerpins die Referenzelemente, insbesondere die äußerst angeordneten Steckerpins innerhalb einer oder mehrerer paralleler Steckerpinreihen, welche dann in entsprechende Aussparungen zumindest eines Teiles eines Ausformwerkzeuges eingreifen. Durch diese Maßnahmen können minimalste Toleranzketten erwirkt werden.

Eine weitere günstige Ausführungsform ergibt sich dadurch, dass am Steckerkragen ein Steckverdrehschutz (beispielsweise eine Kushiri-Sicherheit) und/oder Führungselemente für den Gegenstecker, beispielsweise innerhalb der Öffnung, und/oder Verriegelungselemente für den Gegenstecker, beispielsweise außerhalb der Öffnung an einer Außenfläche des Steckerkragens, aus der verfestigten Umhüllungsmasse angeformt sind. Insofern kann ein Steckeranschluss integral im Elektronikmodul ausgebildet sein, welcher korrespondierend mit einem Standdardgegenstecker ein sichere und dichte Steckverbindung ausbilden kann.

Zur Optimierung der Fertigung und zur Erreichung hoher Qualitätsergebnisse ist eine Ausführungsform des Elektronikmodules dadurch besonders vorteilhaft, bei welcher der Pinträger Werkzeughalteelemente aufweist, insbesondere als angeformte Haltezapfen und/oder als ausgeformte Halteaussparungen, welche ausgebildet sind in Anlagekontakt mit zumindest einem Teil eines Abformwerkzeuges, beispielsweise über einen Kraft- und/oder Formschluss, während der Ausbildung des Steckerkragens und der Schutzumhausung wirkende Prozesskräfte diese in das Abformwerkzeug abzuleiten. Derartige Prozesskräfte können beispielsweise verursacht sein durch einen Einspritzdruck der Umhüllungsmasse und/oder oder durch erforderliche Dichtkräfte an zumindest einem Teil des Abformwerkzeuges. Durch die beschriebene Maßnahme bleibt ein als Einlegeteil eingesetztes zuvor beschriebenes Steckerelement jederzeit lagestabil bis zur Verfestigung der Umhüllungsmasse. Der Pinträger ist als Volumenkörper ausgebildet mit beispielsweise zwei parallel zueinander orientierten Pinträgerflächen, die von den Steckerpins durchdrungen sind und die Pinträgerflächen über ein diese jeweils umrandende Seitenfläche verbunden sind, wobei die Werkzeughalteelemente an der umrandeten Seitenfläche angeformt und/oder ausgeformt sind, bevorzug paarweise auf sich gegenüberliegenden Bereichen der umrandeten Seitenfläche. Insbesondere weisen dabei die Werkzeughalteelemente demnach einer Ausrichtachse auf, die senkrecht zur Pinträgerfläche auf der Steckerseite und/oder der Anschlussseite orientiert ist.

Die Erfindung führt auch zu einem Verfahren zur Ausbildung eines Elektronikmoduls mit einem Steckeranschluss zur elektrischen Kontaktierung mit einem Gegenstecker, insbesondere nach einer der zuvor beschriebenen Ausführungsformen. Das Verfahren umfasst hierbei zumindest nachfolgende Verfahrensschritte:
a) Bereitstellen eines Steckerelements umfassend einen Pinträger, welcher von einer Anzahl von Steckerpins durchdrungen ist, welche auf einer Seite einer durchdrungenen Pinträgerfläche eine Steckerseite ausbilden zur elektrischen Kontaktie rung mit einem Gegenstecker und auf einer weiteren Seite einer anderen durchdrungenen Pinträgerfläche eine Anschlussseite ausbilden zur elektrischen Verbindung mit einem Schaltungsträger,
b) Ausbildung einer Elektronikeinheit, indem die Anschlussseite mit einem Schaltungsträger elektrisch verbunden wird, beispielsweise durch einen jeweiligen Lot- oder Einpresskontakt an einem Steckerpin,
c) Einlegen der Elektronikeinheit in ein insbesondere mehrteiliges Ausformwerkzeug, in welches bei geschlossenem Zustand eine fließfähige Umhüllungsmasse eingebracht wird, insbesondere durch einen Spritzgussprozess, beispielsweise durch ein Direct-Injection-Molding-Verfahren, durch ein Transfermolding-Verfahren, durch ein Compressionsmold-Verfahren oder durch ein Spritzgussverfahren,
d) Ausformen einer Außengeometrie des Elektronikmodules mit einer Steckergeometrie des Steckeranschlusses, wobei der Pinträger als Einlegeteil von der Umhüllungsmasse innerhalb einer Öffnung eines ausgeformten Steckerkragens des Steckeranschlusses umschlossen wird, wobei der Steckerkragen und eine Schutzumhausung mit einer vollständig nach außen hin geschlossenen Außenfläche (82) des Elektronikmodules (200) einstückig mit einem außerhalb des Pinträgers am Steckerkragen ausgebildeten Dichtbereichs aus der verfestigten Umhüllungsmasse ausgebildet wird, und wobei lediglich die Pinträgerfläche (25a) vor der Umhüllungsmasse (70) freigelegt ausgebildet wird.

Insbesondere ist das Steckerelement im Bereich der Steckerpins spritzdicht ausgeführt, insbesondere spaltfrei zwischen dem Pinträger und den Steckerpins.

In einer bevorzugten Ausführungsform des Verfahrens wird zumindest ein Teil des Ausformwerkzeuges, insbesondere als Schiebewerkzeug, beim Einlegen der Elektronikeinheit gemäß dem Verfahrensschritt c) in Anlagenkontakt, insbesondere kraftbeauschlagt, zu einer auf der Steckerseite an der Pinträgerfläche ausgebildeten Dichtfläche gebracht, so dass beim Einbringen der fließfähigen Umhüllungsmasse ein vom dem aufliegenden Teil des Umformwerkzeuges abgedeckter Bereich der Pinträgerfläche von der Umhüllungsmasse freigehalten wird. Dabei sind die Steckerpins innerhalb des Ausformwerkzeuges aufgenommen, beispielsweise innerhalb eines Hohlraumes. Über das Schiebewerkzeug wird eine Steckergeometrie am Steckerkragen ausgeformt, insbesondere innerhalb der Öffnung.

Bei einer weitergehenden Ausführungsform des Verfahrens ergeben sich weitere Vorteile dadurch, dass beim Einlegen gemäß dem Verfahrensschritt c) am Pinträger angeformte und/oder ausgeformte Werkzeughalteelemente zumindest mit einem Teil des Ausformwerkzeuges in Eingriff gebracht werden, beispielsweise durch einen Kraft- und/oder Formschluss, so dass während des Einbringens der fließfähigen Umhüllungsmasse wirkende Prozesskräfte, beispielsweise aufgrund eines Einspritzdruckes der Umhüllungsmasse, diese in zumindest einen eingreifenden Teil des Ausformungswerkzeuges abgeleitet werden. Ein Ausformen im Bereich der Werkzeughalteelemente erfolgt dann bevorzugt mittels eines Kernzugs, beispielsweise bei einem Füllgrad von 95 - 99% der fließfähigen Umhüllungsmasse, wobei nach dem Kernzug die Umhüllungsmasse in die entstandenen Hohlräume nachfließt, insbesondere bei einem Nachdruck kleiner als der Einspritzdruck der Umhüllungsmasse. Vorteilhaft ist, wenn der Schaltungsträger im Bereich der Werkzeughalteelemente Aussparungen aufweist, die koaxial zu einer Ausrichtachse der Werkzeughalteelement angeordnet sind und die Aussparungen dabei von angeformten Haltezapfen durchdrungen sind, die auf der anderen Seite des Schaltungsträgers in zumindest ein Teil eines Ausformwerkzeuges eingreifen und/oder Haltestifte zumindest eines Teiles eines Ausformwerkzeuges die Aussparungen innerhalb des Schaltungsträgers durchdringen und in die ausgeformten Halteaussparungen eingreifen. Auf diese Weise kann eine besonders gute Lagestabilisierung des Steckerelementes während der Ausbildung des Elektronikmodules erreicht werden.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
- Fig. 1a:: eine perspektivische Darstellung eines Ausführungsbeispieles des Elektronikmodules aus einer ersten Perspektive,
- Fig. 1b:: eine perspektivische Darstellung des Elektronikmodules von Fig. 1a aus einer anderen Perspektive,
- Fig. 2a:: perspektivische Darstellung eines Steckerelement zu einem Zeitpunkt kurz vor der elektrischen Verbindung mit einem Schaltungsträger aus einer ersten Perspektive,
- Fig. 2b:: perspektivische Darstellung des Steckerelementes von Fig. 2a zu einem Zeitpunkt nach der elektrischen Verbindung mit dem Schaltungsträger aus einer anderen Perspektive,
- Fig. 3:: Teilausschnitt einer in einem mehrteiligen Ausformwerkzeug eingelegten Elektronikeinheit zur Ausbildung des Elektronikmodules, beispielsweise aus Fig. 1a, in einer seitlichen Schnittdarstellung.
- Fig. 4:: einen Bereich eines Steckerpins innerhalb des Pinträgers vergrößert in einer Teilschnittdarstellung.

### Ausführungsformen der Erfindung

In den Figuren sind funktional gleiche Bauelemente jeweils mit gleichen Bezugszeichen gekennzeichnet.

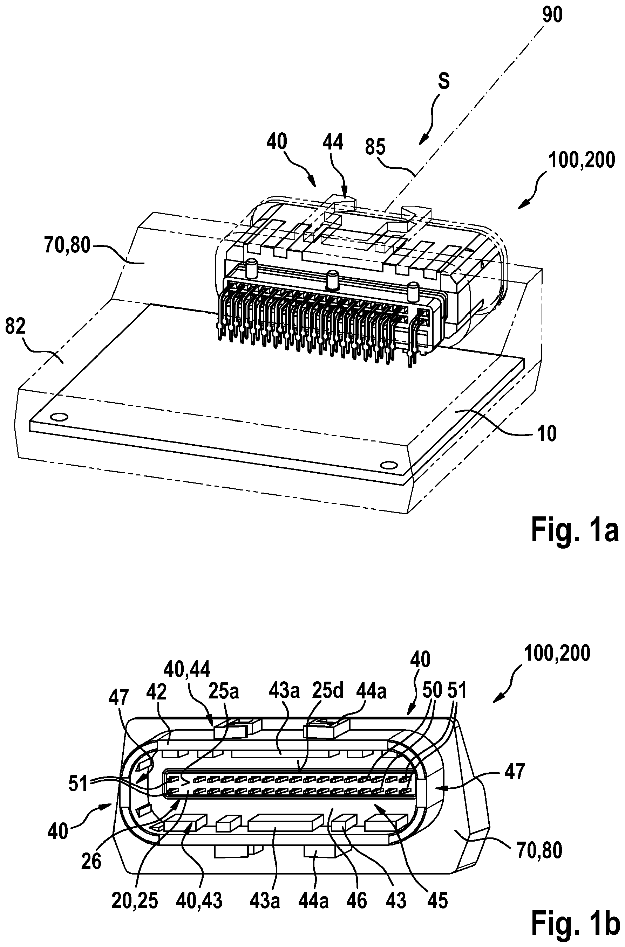

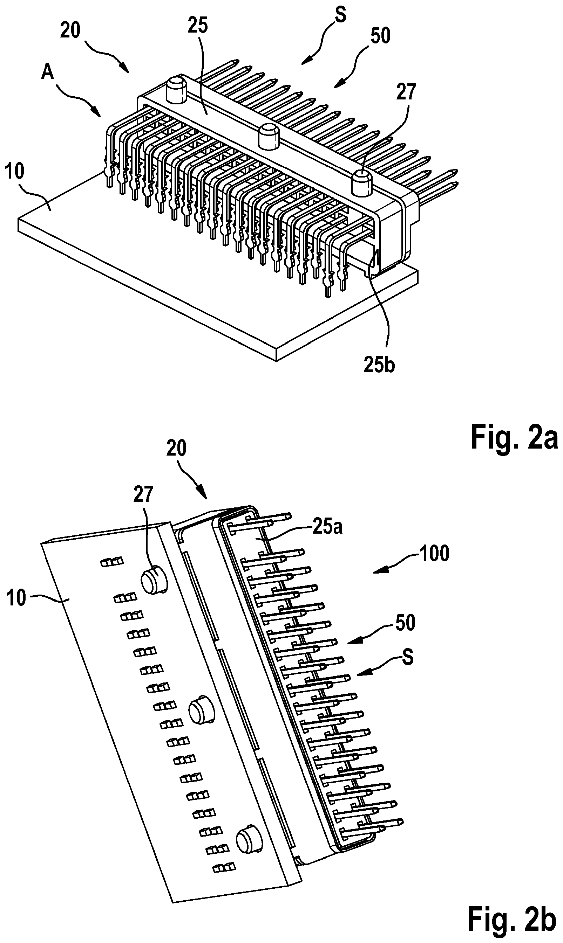

In der Fig. 1 ist eine beispielhafte Ausführung eines Elektronikmodules 200 aus einer ersten Perspektive gezeigt. Bei dem Elektronikmodul 200 ist eine Elektronikeinheit 100 von einer verfestigten Umhüllungsmasse 70 unter Ausbildung einer Schutzumhausung 80 umschlossen. Die Elektronikeinheit 100 umfasst hierbei einen einseitig oder beidseitig bestückten Schaltungsträger 10, beispielsweise eine Leiterplatte. Ferner ist die Elektronikeinheit 100 bzw. das Elektronikmodul 200 über einen Steckeranschluss 40 von außen elektrisch durch einen Gegenstecker 90 in einer Steckrichtung 85 kontaktierbar. Die Fig. 2b zeigt das Elektronikmodul 200 aus der Fig. 2a mit einer perspektivischen Sicht auf den Steckeranschluss 40. Der Steckeranschluss 40 umfasst dabei zumindest einen Steckerkragen 42, welcher im Wesentlichen eine zum Gegenstecker 90 korrespondierende innere und/oder äußere Steckergeometrie 43, 44 aufweist. Die Steckergeometrie 43, 44 ist mitunter bestimmt durch eine Öffnung 45, welche zur Aufnahme des Gegensteckers 90 durch den Steckerkragen 42 ausgeformt ist. In Steckrichtung 85 ist die Öffnung von einem Steckergrund 46 begrenzt. An den inneren Seitenflächen der Öffnung 45 sind beispielsweise als Teil der inneren Steckergeometrie 43 ein Steckverdrehschutz 43a, beispielsweise als Kushiri-Sicherheit, und/oder Führungselemente 43b für den Gegenstecker 90 am Steckerkragen 42 mit ausgeformt. Ferner können als Teil der äußeren Steckergeometrie 44 an einer Außenseite des Steckerkragens 42 Verriegelungselemente 44a angeformt sein. Innerhalb der Öffnung 45 sind eine Vielzahl von Steckerpins 50 angeordnet, beispielsweise in einer oder mehreren parallelen Reihen zueinander. Der Steckerkragen 42 und die Schutzumhausung 80 sind einstückig aus der verfestigten Umhüllungsmasse 70 ausgebildet, insbesondere aus einem Duroplasten, und bilden damit eine nach außen hin geschlossene Außenfläche 82 des Elektronikmodules 200 aus. Innerhalb der Öffnung 45 ist ein Pinträger 25 zumindest teilweise von der verfestigten Umhüllungsmasse 70 umschlossen. Der Pinträger 25 ist Teil eines Steckerelementes 20, wie es in Fig. 2a und 2b perspektivisch gezeigt ist. Das Steckerelement 20 ist dabei als Einlegeteil für ein Ausformungswerkzeug 60 konzipiert zur teilweisen Umschließung durch die Umhüllungsmasse 70. Mit der verfestigten Umhüllungsmasse 70 und dem von dieser umschlossenen Pinträger 25 ist insgesamt ein isolierter Steckerkörper 41 des Steckeranschlusses 40 ausgebildet, welcher einem Steckerkörper von bekannten Messerleisten im Wesentlichen entspricht oder in Anlehnung an diese ausgeformt ist. Insbesondere eignet sich dann dieser zur Verwendung von an für sich bekannten Standardgegensteckern 90 zur Ausbildung einer elektrischen Steckverbindung mit dem Elektronikmodul 200. Der Pinträger 25 weist eine dem Gegenstecker 90 zugewandte Pinträgerfläche 25a auf, welche von der Umhüllungsmasse 70 freiliegt. Die Pinträgerfläche 25a weist dabei eine Berandung 26 auf, welche alle Steckerpins 50 umrahmt. Die freiliegende Pinträgerfläche 25a liegt in diesem Ausführungsbeispiel innerhalb des Steckergrundes 46, wobei die Berandung 26 beispielsweise einen Abstand zur Innenfläche der Öffnung 45 aufweist. Der Pinträger 25 ist bevorzugt aus einem Thermoplast-Material ausgebildet. Im Bereich der Berandung 26 ist demnach auch eine Stoßstelle bzw. ein Berührbereich gegeben zwischen dem Material des Pinträgers 25 und dem Material der verfestigten Umhüllungsmasse 70. Außerhalb des Pinträgers 25 und damit noch vor dieser Stoßstelle bzw. diesem Berührbereich ist für den Steckeranschluss 40 dann ein Dichtbereich 47 am Steckerkragen 42 ausgebildet, beispielsweise am Eingangsbereich der Öffnung 45 und/oder innerhalb der Öffnung 45. Der Dichtbereich 47 kann hierbei beispielsweise eine Dichtfläche und/oder ein Dichtelement umfassen.

In der Fig. 2a ist das Steckerelement 20, umfassend den Pinträger 25 und die Steckerpins 50, zu einem Zeitpunkt kurz vor der elektrischen Verbindung mit dem Schaltungsträger 10 gezeigt. Der Pinträger 25 ist ein Volumenkörper mit beispielsweise den beiden Pinträgerflächen 25a, 25b und einer umlaufenden Seitenfläche 25c. Von der Seitenfläche 25c abstehend sind mehrere Werkzeughalteelemente 27 mit angeformt. Der Pinträger 25 ist von den Steckerpins 50 durchdrungen, wobei auf der einen durchstoßenen Pinträgerfläche 25a dann eine Steckseite S des Steckerelementes 20 zur elektrischen Kontaktierung mit dem Gegenstecker 90 vorliegt und auf der anderen Pinträgerfläche 25b eine Anschlussseite A zur elektrischen Kontaktierung mit dem Schaltungsträger 10. Indem auf der Anschlussseite A die Enden der Steckerpins 50 mit Anschlusskontaktstellen des Schaltungsträgers 10 verbunden werden, beispielsweise als Lotoder Einpresskontakt, wird die Elektronikeinheit 100 ausgebildet. Die Elektronikeinheit 100 ist in Fig. 2b mit Sicht auf die Steckerseite S perspektivisch gezeigt. Zu erkennen ist, dass Werkzeughalteelemente 27 hierbei auch den Schaltungsträger, bevorzugt zumindest berührend oder einpressend, durchdringen und von der dem Pinträger 25 abgewandten Seite des Schaltungsträgers 10 abstehen.

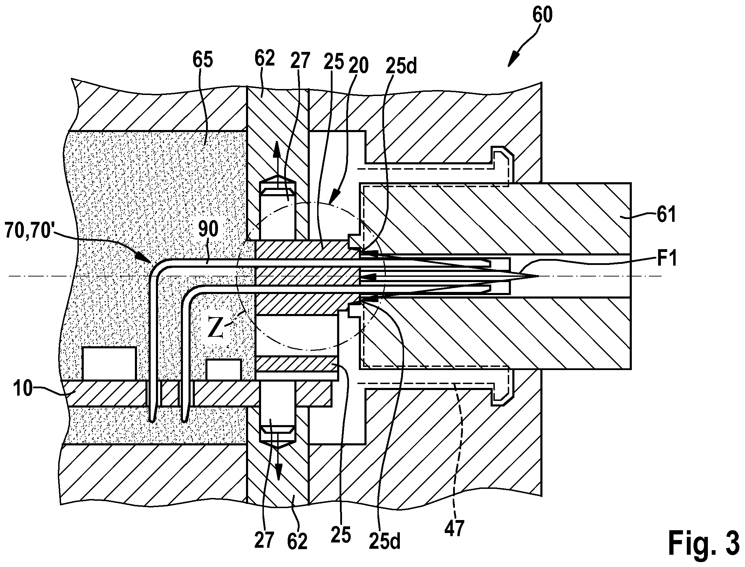

In der Fig. 3 ist in einer Teilansicht in einer seitlichen Schnittdarstellung ein geschlossenes mehrteiliges Ausformwerkzeug 60 gezeigt, in welches die Elektronikeinheit 100 zur Ausbildung des Elektronikmodules 200 eingelegt wird. Das mehrteilige Ausformwerkzeug 60 umfasst dabei zumindest ein Schiebewerkzeug 61, welches mit einer Stirnfläche auf einen Werkzeugdichtfläche 25d der Pinträgerfläche 25a auf der Steckerseite S aufliegt, insbesondere mit einer Dichtkraft F1. Die Werkzeugdichtfläche 25d umfasst bevorzugt eine Schmelzrippe. Dadurch wird zumindest ein Teil der Pinträgerfläche 25a von der Stirnfläche des Schiebewerkzeuges 61 überdeckt und somit von einer fließfähigen Umhüllungsmasse 70' freigehalten. Die Steckerpins 50 sind dabei innerhalb von zumindest einem Hohlraum im Schiebewerkzeug 61 aufgenommen. Einzelne Steckerpins 50, insbesondere die außen in einer Steckerpinreihe angeordneten, greifen als Referenzelemente 51 anliegend in das Schiebewerkzeug 61 ein, um bei der Ausbildung der korrespondierenden Steckergeometrie 43, 44 diese in Bezug zu den Steckerpins 50 lagerichtig festzulegen. Zusätzlich greifen die am Pinträger 25 ausgeformten Werkzeughalteelemente 27 in Teile des Ausformwerkzeuges 60 ein, so dass die Position des Steckerelementes 20 und/oder des Schaltungsträgers 10 in ihrer Lage und/oder Ausrichtung fixiert sind. Das geschlossene mehrteilige Ausformwerkzeug 60 umschließt einen Hohlraum 65. Durch Einbringen einer fließfähigen Umhüllungsmasse 70', beispielsweise durch ein Direct-Injection-Molding-Verfahren, durch ein Transfermolding-Verfahren, durch ein Compressionsmold-Verfahren oder durch ein Spritzgussverfahren, wird eine Außengeometrie des Elektronikmoduls 200 ausgeformt. Dabei wird der Pinträger 25 von der Umhüllungsmasse 70' bis auf die freigehaltene Pinträgerfläche 25a umschlossen. Zusätzlich wir die Schutzumhausung 80 zusammen mit dem Steckerkragen 42 und der inneren und/oder äußeren Steckergeometrie 43, 44 einstückig ausgeformt. Außerhalb der freigehaltenen Pinträgerfläche 25a wird insbesondere im Bereich der Öffnung 45 ein Dichtbereich 47 mit ausgebildet, beispielsweise als eine Dichtfläche. Die zeitlich wirkenden Prozesskräfte, beispielsweise ein Einpressdruck der fließfähigen Umhüllungsmasse 70' oder die Dichtkraft F1 des Schiebewerkzeuges 61 werden über die eingreifenden Werkzeughalteelemente 27 in das mehrteilige Ausformwerkzeug 60 abgeleitet. Die Werkzeughalteelemente 27 werden über einen Kernzug 62 entformt, so dass fließfähige Umhüllungsmasse 70' dort nachfließen kann, bevor die gesamte Umhüllungsmasse 70 verfestigt ist.

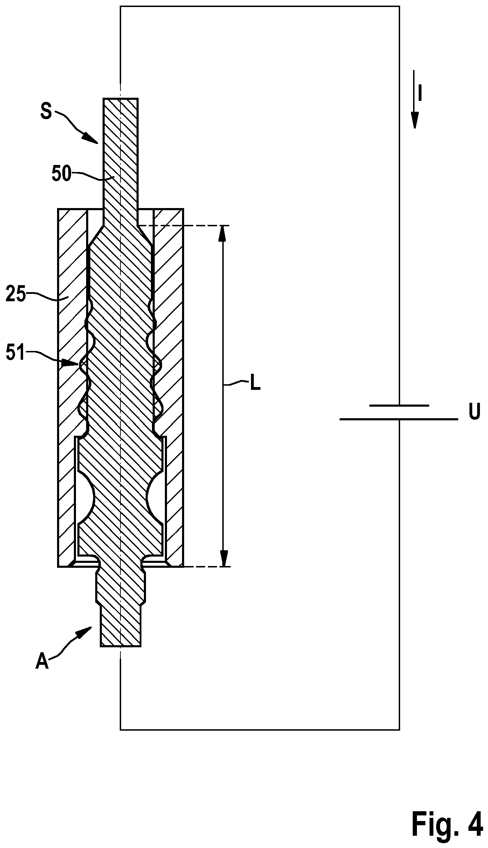

In der Fig. 4 ist ein aus Fig. 3 vergrößerter Bereich Z eines Steckerpins 50 innerhalb des Pinträgers 25 dargestellt. Zu Verbesserung einer Spritzdichtheit in diesem Bereich, weist der Steckerpin 50 über eine Abschnittslänge L abstehende Strukturen 52 auf, beispielsweise als Tannenbaumstruktur. Zusätzlich kann in einem Teilbereich oder über die gesamte Abschnittslänge L die Oberfläche des Steckerpins 50 aufgerauht sein, beispielsweise durch eine Verprägung oder Laserstrukturierung. Dadurch wird insgesamt eine gute Haftmöglichkeit zum Material des Pinträgers 25 erreicht und die Wahrscheinlichkeit von Spaltbildungen aufgrund des Einfließens in Hinterschneidungen der Tannenbaumstruktur 52 stark verringert. Zusätzlich kann das Steckerelement 20 in einer Art bereitgehalten werden, bei welchen die einzelnen Steckerpins 50 der Reihe nach oder zeitgleich mehrere oder alle Steckerpins 50 durch Anschluss an eine Spannungsquelle U von einem so großen Strom I durchflossen wird, dass diese auf eine Temperatur oberhalb der Schmelztemperatur des Materials des Pinträgers 25 erwärmt werden. Dadurch kann lokal aufgeschmolzenes Material bis an den jeweiligen Steckerpin 50 nachfließen und nach einem Verfestigen ggf. zuvor vorgelegene Spalte geschlossen werden.

## Patentansprüche

1. Elektronikmodul (200), umfassend zumindest einen bestückten Schaltungsträger (10) mit einem Steckeranschluss (40) zur elektrischen Kontaktierung mit einem Gegenstecker (90), wobei der Steckeranschluss (40) einen elektrisch isolierenden Steckerkörper (41) mit zumindest einem Steckerkragen (42) umfasst, durch welchen eine Öffnung (45) zur Aufnahme des Gegensteckers (90) in Richtung eines Steckergrundes (46) ausgebildet ist, wobei der Steckerkörper (41) einen Dichtbereich(47) gegenüber dem Gegenstecker (90) aufweist und innerhalb der Öffnung (45) von einer Anzahl von Steckerpins (50) durchdrungen ist, wobei der Steckeranschluss (40) innerhalb der Öffnung (45) einen Pinträger (25) aufweist, welcher zumindest den von den Steckerpins (50) durchdrungenen Bereich des Steckerkörpers (41) ausbildet und der Pinträger (25) auf einer dem Gegenstecker (90) zugewandten Steckerseite (S) zumindest eine nach außen weisende Pinträgerfläche (25a) aufweist, und wobei der Schaltungsträger (10) unter Ausbildung einer Schutzumhausung (80) zumindest bereichsweise von zumindest einer verfestigten Umhüllungsmasse (70) umschlossen ist, und wobei eine zur Umhüllungsmasse (70) angrenzende Berandung (26) der Pinträgerfläche (25a) die Steckerpins (50) umrahmt,
**dadurch gekennzeichnet, dass**
der Steckerkragen (42) und die Schutzumhausung (80) mit einer vollständig nach außen hin geschlossenen Außenfläche (82) des Elektronikmodules (200) einstückig aus der verfestigten Umhüllungsmasse (70) ausgebildet sind und der Pinträger (25) von der Umhüllungsmasse (70) umschlossen ist, wobei lediglich die Pinträgerfläche (25a) von der Umhüllungsmasse (70) freiliegt, und wobei der Pinträger (25) Werkzeughalteelemente (27) aufweist, welche ausgebildet sind, in Anlagekontakt mit zumindest einem Teil eines Abformwerkzeuges (60), während der Ausbildung des Steckerkragens (42) und der Schutzumhausung (80) wirkende Prozesskräfte diese in das Abformwerkzeug (60) abzuleiten, und wobei der Dichtbereich (47) außerhalb des Pinträgers (25) am Steckerkragen (42) ausgebildet und im Eingangsbereich der Öffnung und/oder innerhalb der Öffnung angeordnet ist, so dass die von außen sichtbare Außenfläche des Elektronikmodules (200) geschlossen aus der Umhüllungsmasse ausgeführt ist.

2. Elektronikmodul (200) nach Anspruch 1,
**dadurch gekennzeichnet, dass**
der Pinträger (25) und die Steckerpins (50) ein Steckerelement bilden, das im Bereich der Steckerpins (50) spaltfrei zwischen dem Pinträger (25) und den Steckerpins (50) ausgebildet ist.

3. Elektronikmodul (200) nach einem der Ansprüche 1 oder 2,
**dadurch gekennzeichnet, dass**
die Umhüllungsmasse (70) ein Duroplast ist und der Pinträger (25) aus einem Thermoplast oder aus einem Duroplast ausgebildet ist.

4. Elektronikmodul (200) nach einem der vorhergehenden Ansprüche,
**dadurch gekennzeichnet, dass**
der Dichtbereich (47) im Eingangsbereich der Öffnung (45) und/oder innerhalb der Öffnung (45) angeordnet ist.

5. Elektronikmodul (200) nach einem der vorhergehenden Ansprüche,
**dadurch gekennzeichnet, dass**
die Werkzeughalteelemente als angeformte Haltezapfen und/oder als ausgeformte Halteaussparungen ausgebildet sind.

6. Elektronikmodul (200) nach einem der vorhergehenden Ansprüche,
**dadurch gekennzeichnet, dass**
der Bereich der Berandung (26) der Pinträgerfläche (25a) eine Werkzeugdichtfläche (25d) umfasst, insbesondere in Form einer Schmelzrippe, welche ausgebildet ist, die Pinträgerfläche (25a) während einer Ausbildung der Schutzumhausung (80) und des Steckerkragens (42) gegenüber noch nicht verfestigter Umhüllungsmasse (70') mittels der Auflage zumindest eines Teiles eines Ausformwerkzeuges (60) von der Umhüllungsmasse (70', 70) freizuhalten.

7. Elektronikmodul (200) nach einem der vorhergehenden Ansprüche,
**dadurch gekennzeichnet, dass**
die Berandung (26) der Pinträgerfläche (25a) bis höchstens angrenzend zum Dichtbereich (47) reicht, insbesondere bis höchstens zu einer Einstecktiefe des Gegensteckers (90) innerhalb der Öffnung (45), bevorzugt innerhalb des Steckergrundes (46) ausgebildet ist.

8. Elektronikmodul (200) nach einem der vorhergehenden Ansprüche,
**dadurch gekennzeichnet, dass**
zumindest ein Teil der Flächen des Steckerkragens (42) in Steckrichtung (S) des Gegensteckers (90) Entformungsschrägen eines Abformwerkzeuges (60) aufweisen, insbesondere innerhalb der Öffnung (45), wobei durch die entsprechend zugeordneten entformten Flächen eine innere und äußere korrespondierende Steckergeometrie (43, 44) für den Gegenstecker (90) ausgebildet ist.

9. Elektronikmodul (200) nach Anspruch 7,
**dadurch gekennzeichnet, dass**
der Pinträger (25) Referenzelemente (51) umfasst, welche ausgebildet sind in Anlagenkontakt mit zumindest einem Teil eines Abformwerkzeuges (60, 61) dieses relativ zu den Steckerpins (50) zu positionieren, um bei der Ausbildung der korrespondierenden Steckergeometrie (43, 44) diese in Bezug zu den Steckerpins (50) lagerichtig festzulegen.

10. Elektronikmodul (200) nach einem der vorhergehenden Ansprüche,
**dadurch gekennzeichnet, dass**
am Steckerkragen (42) ein Steckverdrehschutz (43a) und/oder Führungselemente (43b) für den Gegenstecker (90), beispielsweise innerhalb der Öffnung (45), und/oder Verriegelungselement des Steckerkragens (42), aus der verfestigten Umhüllungsmasse (70) angeformt sind.

11. Verfahren zur Ausbildung eines Elektronikmoduls (200) mit einem Steckeranschluss (40) zur elektrischen Kontaktierung mit einem Gegenstecker (90), insbesondere nach einem der Ansprüche 1 bis 10, mit zumindest nachfolgenden Verfahrensschritten:
a) Bereitstellen eines Steckerelements (20) umfassend einen Pinträger (25), welcher von einer Anzahl von Steckerpins (50) durchdrungen ist, welche auf einer Seite einer durchdrungenen Pinträgerfläche (25a) eine Steckerseite (S) ausbilden zur elektrischen Kontaktierung mit einem Gegenstecker (90) und auf einer weiteren Seite einer anderen durchdrungenen Pinträgerfläche (25b) eine Anschlussseite (A) ausbilden zur elektrischen Verbindung mit einem Schaltungsträger (10),
b) Ausbildung einer Elektronikeinheit (100), indem die Anschlussseite (A) mit einem Schaltungsträger (10) elektrisch verbunden wird, beispielsweise durch einen jeweiligen Lot- oder Einpresskontakt an einem Steckerpin (50),
c) Einlegen der Elektronikeinheit (100) in ein insbesondere mehrteiliges Ausformwerkzeug (60), in welches bei geschlossenem Zustand eine fließfähige Umhüllungsmasse (70') eingebracht wird, insbesondere durch einen Spritzgussprozess, beispielsweise durch ein Direct-Injection-Molding-Verfahren, durch ein Transfermolding-Verfahren, durch ein Compressionsmold-Verfahren oder durch ein Spritzgussverfahren,
d) Ausformen einer Außengeometrie des Elektronikmodules (200) mit einer Steckergeometrie (43, 44) des Steckeranschlusses (40), wobei der Pinträger (25) als Einlegeteil von der Umhüllungsmasse (70, 70`)innerhalb einer Öffnung (45) eines ausgeformten Steckerkragens (42) des Steckeranschlusses (40) umschlossen wird, wobei der Steckerkragen (42) und eine Schutzumhausung (80) mit einer vollständig nach außen hin geschlossenen Außenfläche (82) des Elektronikmodules (200) einstückig mit einem außerhalb des Pinträgers (25) am Steckerkragen (42) ausgebildeten Dichtbereichs (47) aus der verfestigten Umhüllungsmasse (70) ausgebildet wird, und wobei lediglich die Pinträgerfläche (25a) von der Umhüllungsmasse (70) freigelegt ausgebildet wird,
e) wobei beim Einlegen der Elektronikeinheit (100) gemäß dem Verfahrensschritt c) am Pinträger (25) angeformte und/oder ausgeformte Werkzeughalteelemente (27) zumindest mit einem Teil des Ausformwerkzeuges (60) in Eingriff gebracht werden, beispielsweise durch einen Kraft- und/oder Formschluss, so dass während des Einbringens der fließfähigen Umhüllungsmasse (70') wirkende Prozesskräfte, beispielsweise aufgrund eines Einspritzdruckes der Umhüllungsmasse (70'), diese in zumindest einen eingreifenden Teil des Ausformungswerkzeuges (60) abgeleitet werden.

12. Verfahren nach Anspruch 11,
**dadurch gekennzeichnet, dass**
zumindest ein Teil des Ausformwerkzeuges (60, 61), insbesondere als Schiebewerkzeug, beim Einlegen der Elektronikeinheit (100) gemäß dem Verfahrensschritt c) in Anlagenkontakt, insbesondere kraftbeaufschlagt, zu einer auf der Steckerseite (S) an der Pinträgerfläche (25a) ausgebildeten Werkzeugdichtfläche (25d) gebracht wird, so dass beim Einbringen der fließfähigen Umhüllungsmasse (70') ein vom dem aufliegenden Teil des Umformwerkzeuges (60, 61) abgedeckter Bereich der Pinträgerfläche (25a) von der Umhüllungsmasse (70, 70') freigehalten wird.

## Claims

1. Electronics module (200), comprising at least one populated circuit carrier (10) having a plug connection (40) for electrical contact-connection to a mating plug (90), wherein the plug connection (40) comprises an electrically insulating plug body (41) with at least one plug collar (42), by way of which an opening (45) for receiving the mating plug (90) in the direction of a plug base (46) is formed, wherein the plug body (41) has a sealing region (47) in relation to the mating plug (90) and a number of plug pins (50) pass through the plug body within the opening (45), wherein the plug connection (40) has a pin carrier (25) within the opening (45), which pin carrier forms at least the region of the plug body (41) through which the plug pins (50) pass, and the pin carrier (25) has at least one outwardly facing pin carrier surface (25a) on a plug side (S) facing the mating plug (90), and wherein the circuit carrier (10) is enclosed, at least in regions, by at least one solidified encapsulation compound (70) so as to form a protective enclosure (80), and wherein a boundary (26), which is adjacent to the encapsulation compound (70), of the pin carrier surface (25a) frames the plug pins (50),
**characterized in that**
the plug collar (42) and the protective enclosure (80) are formed from the solidified encapsulation compound (70) in one piece with an outer face (82), which is completely closed to the outside, of the electronics module (200) and the pin carrier (25) is enclosed by the encapsulation compound (70), wherein only the pin carrier surface (25a) is free of the encapsulation compound (70), and wherein the pin carrier (25) has tool holding elements (27) which are designed, when in bearing contact with at least a portion of a moulding tool (60), to dissipate process forces acting during forming of the plug collar (42) and the protective enclosure (80) these into the moulding tool (60), and wherein the sealing region (47) is formed outside the pin carrier (25) on the plug collar (42) and is arranged in the entry region of the opening and/or within the opening, so that the outer surface of the electronics module (200) that is visible from the outside is cohesively formed from the encapsulation compound.

2. Electronics module (200) according to Claim 1,
**characterized in that**
the pin carrier (25) and the plug pins (50) form a plug element which is formed between the pin carrier (25) and the plug pins (50) without gaps in the region of the plug pins (50).

3. Electronics module (200) according to either of Claims 1 and 2,
**characterized in that**
the encapsulation compound (70) is a thermoset and the pin carrier (25) is formed from a thermoplastic or from a thermoset.

4. Electronics module (200) according to any of the preceding claims,
**characterized in that**
the sealing region (47) is arranged in the entry region of the opening (45) and/or within the opening (45).

5. Electronics module (200) according to any of the preceding claims,
**characterized in that**
the tool holding elements are designed as integrally formed retaining pins and/or as shaped retaining cutouts.

6. Electronics module (200) according to any of the preceding claims,
**characterized in that**
the region of the boundary (26) of the pin carrier surface (25a) comprises a tool sealing surface (25d), in particular in the form of a melting fin, which is designed to keep the pin carrier surface (25a) free of encapsulation compound (70', 70) during forming of the protective enclosure (80) and the plug collar (42) with respect to not yet solidified encapsulation compound (70') by means of supporting at least a portion of a shaping tool (60).

7. Electronics module (200) according to any of the preceding claims,
**characterized in that**
the boundary (26) of the pin carrier surface (25a) extends as far as at most adjacent to the sealing region (47), in particular as far as at most to an insertion depth of the mating plug (90) within the opening (45), preferably within the plug base (46).

8. Electronics module (200) according to any of the preceding claims,
**characterized in that**
at least some of the surfaces of the plug collar (42) have demoulding slopes of a moulding tool (60) in the plug-in direction (S) of the mating plug (90), in particular within the opening (45), wherein an inner and outer corresponding plug geometry (43, 44) for the mating plug (90) is formed by the correspondingly associated demoulded surfaces.

9. Electronics module (200) according to Claim 7,
**characterized in that**
the pin carrier (25) comprises reference elements (51) which are designed, when in bearing contact with at least a portion of a moulding tool (60, 61), to position this moulding tool relative to the plug pins (50) in order to fix the corresponding plug geometry (43, 44) in the correct position in relation to the plug pins (50) when forming the plug geometry.

10. Electronics module (200) according to any of the preceding claims,
**characterized in that**
a plug-in rotation-prevention means (43a) and/or guide elements (43b) for the mating plug (90), for example within the opening (45), and/or a locking element of the plug collar (42) are/is integrally formed from the solidified encapsulation compound (70) on the plug collar (42) .

11. Method for forming an electronics module (200) having a plug connection (40) for electrical contact-connection to a mating plug (90), in particular according to any of Claims 1 to 10, comprising at least the following method steps:
a) providing a plug element (20) comprising a pin carrier (25) through which a number of plug pins (50) pass, which plug pins form a plug side (S) on a side of a penetrated pin carrier surface (25a) for electrical contact-connection to a mating plug (90) and form a connection side (A) on a further side of another penetrated pin carrier surface (25b) for electrical connection to a circuit carrier (10),
b) forming an electronics unit (100) by way of the connection side (A) being electrically connected to a circuit carrier (10), for example by means of a respective solder or press-in contact on a plug pin (50),
c) inserting the electronics unit (100) into an, in particular multipartite, shaping tool (60) into which, in the closed state, a flowable encapsulation compound (70') is introduced, in particular by means of an injection moulding process, for example by means of a direct injection moulding method, by means of a transfer moulding method, by means of a compression moulding method or by means of an injection moulding method,
d) shaping an outer geometry of the electronics module (200) with a plug geometry (43, 44) of the plug connection (40), wherein the pin carrier (25), as an insert part, is enclosed by the encapsulation compound (70, 70') within an opening (45) of a shaped plug collar (42) of the plug connection (40), wherein the plug collar (42) and a protective enclosure (80) with an outer face (82), which is completely closed to the outside, of the electronics module (200) are integrally formed from the solidified encapsulation compound (70) with a sealing region (47) formed outside the pin carrier (25) on the plug collar (42), and wherein only the pin carrier surface (25a) is formed to be free of the encapsulation compound (70),
e) wherein, when the electronics unit (100) is inserted according to method step c), tool holding elements (27) integrally formed and/or shaped on the pin carrier (25) are brought into engagement at least with a portion of the shaping tool (60), for example by means of a force-fitting and/or interlocking connection, so that process forces acting during the introduction of the flowable encapsulation compound (70'), for example on account of an injection pressure of the encapsulation compound (70'), these are dissipated into at least one engaging portion of the shaping tool (60).

12. Method according to Claim 11,
**characterized in that**
during insertion of the electronics unit (100) according to method step c), at least a portion of the shaping tool (60, 61), in particular in the form of a sliding tool, is brought into bearing contact, in particular with application of force, with a tool sealing surface (25d) formed on the plug side (S) on the pin carrier surface (25a), so that, when the flowable encapsulation compound (70') is introduced, a region of the pin carrier surface (25a) covered by the overlying portion of the shaping tool (60, 61) is kept free of the encapsulation compound (70, 70').

## Revendications

1. Module électronique (200), comprenant au moins un support de circuit (10) équipé avec un raccord de connecteur (40) pour une mise en contact électrique avec un connecteur correspondant (90), le raccord de connecteur (40) comprenant un corps de connecteur (41) électriquement isolant avec au moins un collier de connecteur (42), à travers lequel est formée une ouverture (45) pour recevoir le connecteur correspondant (90) en direction d'un fond de connecteur (46), le corps de connecteur (41) présentant une zone d'étanchéité (47) par rapport au connecteur correspondant (90) et étant traversé à l'intérieur de l'ouverture (45) par une pluralité de broches de connecteur (50), le raccord de connecteur (40) présentant, à l'intérieur de l'ouverture (45), un support de broches (25) qui forme au moins la zone du corps de connecteur (41) traversée par les broches de connecteur (50) et le support de broches (25) présentant, sur un côté de connecteur (S) tourné vers le connecteur correspondant (90), au moins une surface (25a) de support de broches dirigée vers l'extérieur, et le support de circuit (10) étant entouré au moins par zones par au moins une masse d'enrobage (70) solidifiée en formant une enveloppe de protection (80), et un bord (26) de la surface (25a) de support de broches, adjacent à la masse d'enrobage (70), encadrant les broches de connecteur (50),
**caractérisé en ce que**
le collier de connecteur (42) et l'enveloppe de protection (80) sont formés, à partir de la masse d'enrobage (70) solidifiée, d'une seule pièce avec une surface extérieure (82) du module électronique (200) complètement fermée vers l'extérieur, et le support de broches (25) est entouré par la masse d'enrobage (70), seule la surface (25a) de support de broches étant dégagée de la masse d'enrobage (70), et le support de broches (25) présentant des éléments (27) de maintien d'outil qui sont conçus, étant en contact avec au moins une partie d'un outil de moulage (60), de façon à dévier dans l'outil de moulage (60) celui-ci les forces de processus qui agissent pendant la formation du collier de connecteur (42) et de l'enveloppe de protection (80), et la zone d'étanchéité (47) étant réalisée à l'extérieur du support de connecteur (25) sur le collier de connecteur (42) et étant agencée, dans la zone d'entrée de l'ouverture et/ou à l'intérieur de l'ouverture, de telle sorte que la surface extérieure visible de l'extérieur du module électronique (200) est rendu fermée par rapport à la masse d'enrobage.

2. Module électronique (200) selon la revendication 1,
**caractérisé en ce que**
le support de broches (25) et les broches de connecteur (50) forment un élément de connecteur qui est réalisé sans interstice entre le support de broches (25) et les broches de connecteur (50) dans la zone des broches de connecteur (50).

3. Module électronique (200) selon l'une des revendications 1 ou 2,
**caractérisé en ce que**
la masse d'enrobage (70) est une matière thermodurcissable et le support de broches (25) est réalisé en une matière thermoplastique ou en une matière thermodurcissable.

4. Module électronique (200) selon l'une des revendications précédentes,
**caractérisé en ce que**
la zone d'étanchéité (47) est agencée dans la zone d'entrée de l'ouverture (45) et/ou à l'intérieur de l'ouverture (45).

5. Module électronique (200) selon l'une des revendications précédentes,
**caractérisé en ce que**
les éléments de maintien de l'outil sont réalisés sous forme de tenons de maintien moulés et/ou d'évidements de maintien moulés.

6. Module électronique (200) selon l'une des revendications précédentes,
**caractérisé en ce que**
la zone du bordure (26) de la surface (25a) de support de broches comprend une surface (25d) d'étanchéité d'outil, en particulier sous la forme d'une nervure de fusion, qui est conçue pour maintenir la surface (25a) de support de broches libre de la masse d'enrobage (70') non encore solidifiée pendant une formation de l'enveloppe de protection (80) et du collier de connecteur (42) au moyen de l'appui d'au moins une partie d'un outil de formage (60) de la masse d'enrobage (70', 70) .

7. Module électronique (200) selon l'une des revendications précédentes,
**caractérisé en ce que**
le bord (26) de la surface (25a) de support de broches s'étend au maximum jusqu'au voisinage de la zone d'étanchéité (47), en particulier au maximum jusqu'à une profondeur d'insertion du connecteur correspondant (90) à l'intérieur de l'ouverture (45), de préférence à l'intérieur du fond de connecteur (46).

8. Module électronique (200) selon l'une des revendications précédentes,
**caractérisé en ce que**
au moins une partie des surfaces du collier de connecteur (42) présentent, dans le sens d'enfichage (S) du connecteur correspondant (90), des pentes de démoulage d'un outil de moulage (60), en particulier à l'intérieur de l'ouverture (45), une géométrie de connecteur (43, 44) interne et externe correspondante étant formée pour le connecteur correspondant (90) par les surfaces démoulées associées de manière correspondante.

9. Module électronique (200) selon la revendication 7,
**caractérisé en ce que**
le support de broches (25) comprend des éléments de référence (51) qui sont conçus de façon à venir en contact d'appui avec au moins une partie d'un outil de moulage (60, 61) pour positionner celui-ci par rapport aux broches de connecteur (50) afin, lors de la formation de la géométrie de connecteur correspondante (43, 44), de fixer celle-ci en position correcte par rapport aux broches de connecteur (50).

10. Module électronique (200) selon l'une des revendications précédentes,
**caractérisé en ce que**
une protection contre la torsion du connecteur (43a) et/ou des éléments de guidage (43b) pour le connecteur correspondant (90), par exemple à l'intérieur de l'ouverture (45), et/ou un élément de verrouillage du collier de connecteur (42), sont formés sur le collier de connecteur (42) à partir de la masse d'enrobage (70) solidifiée.

11. Procédé de réalisation d'un module électronique (200) avec un connecteur (40) pour la mise en contact électrique avec un connecteur correspondant (90), en particulier selon l'une des revendications 1 à 10, comprenant au moins les étapes de procédé suivantes :
a) fourniture d'un élément connecteur (20) comprenant un support de broches (25) qui est traversé par une pluralité de broches de connecteur (50) qui forment, d'un côté d'une surface (25a) de support de broches traversée, un côté de connecteur (S) pour la mise en contact électrique avec un connecteur correspondant (90) et, d'un autre côté d'une autre surface de support de broches (25b) traversée, un côté de connexion (A) pour la connexion électrique à un support de circuit (10),
b) formation d'une unité électronique (100) en reliant électriquement le côté de connexion (A) à un support de circuit (10), par exemple par un contact de soudure ou d'ajustement par pression correspondant sur une broche de connecteur (50),
c) mise en place de l'unité électronique (100) dans un outil de moulage (60), en particulier en plusieurs parties, dans lequel, à l'état fermé, une masse d'enrobage (70') fluide est introduite, en particulier par un processus de moulage par injection, par exemple par un procédé de moulage par injection directe, par un procédé de moulage par transfert, par un procédé de moulage par compression ou par un procédé de moulage par injection,
d) formation d'une géométrie extérieure du module électronique (200) avec une géométrie de connecteur (43, 44) du raccord de connecteur (40), le support de broches (25) étant, en tant que pièce d'insertion, entouré par la masse d'enrobage (70, 70') à l'intérieur d'une ouverture (45) d'un collier de connecteur (42) formé du raccord de connecteur (40), le collier de connecteur (42) et une enveloppe de protection (80) avec une surface extérieure (82) complètement fermée vers l'extérieur du module électronique (200) étant formés d'une seule pièce, une zone d'étanchéité (47) étant formée à l'extérieur du support de broches (25) sur le collier de connecteur (42) à partir de la masse d'enrobage (70) solidifiée, et seule la surface (25a) de support de broches étant formée de manière à être dégagée de la masse d'enrobage (70),
e) lors de l'insertion de l'unité électronique (100) selon l'étape de procédé c), des éléments (27) de maintien d'outil formés et/ou démoulés sur le support de broches (25) sont amenés en prise avec au moins une partie de l'outil de démoulage (60), par exemple par une liaison par adhérence et/ou par complémentarité de forme, de sorte que des forces de processus agissant pendant l'introduction de la masse d'enrobage fluide (70'), par exemple en raison d'une pression d'injection de la masse d'enrobage (70'), celui-ci soient déviées de celles-ci dans au moins une partie en prise de l'outil de démoulage (60) .

12. Procédé selon la revendication 11,
**caractérisé en ce que**
au moins une partie de l'outil de démoulage (60, 61), notamment sous la forme d'un outil coulissant, est amenée, lors de l'insertion de l'unité électronique (100) selon l'étape c) du procédé, en contact d'appui, notamment sous l'effet d'une force, avec une surface (25d) d'étanchéité d'outil formée du côté de connecteur (S) sur la surface (25a) de support de broches, de sorte que, lors de l'introduction de la masse d'enrobage fluide (70'), une zone de la surface (25a) de support de broches recouverte par la partie appliquée de l'outil de formage (60, 61) est maintenue exempte de la masse d'enrobage (70, 70').
